# EUROPÄISCHE PATENTSCHRIFT

(11) **EP 0 868 779 B1**
(45) Veröffentlichungstag und Bekanntmachung des Hinweises auf die Patenterteilung: **17.05.2000**
(21) Anmeldenummer: 96946195.3
(22) Anmeldetag: 16.12.1996
(51) Int. Cl.: H03H 9/05

(54) **ELEKTRONISCHES BAUELEMENT, INSBESONDERE MIT AKUSTISCHEN OBERFLÄCHENWELLEN ARBEITENDES BAUELEMENT - OFW-BAUELEMENT**
ELECTRONIC COMPONENT, ESPECIALLY ONE OPERATING WITH ACOUSTIC SURFACE WAVES (SW COMPONENT)
COMPOSANT ELECTRONIQUE, NOTAMMENT COMPOSANT FONCTIONNANT A L'AIDE D'ONDES DE SURFACE ACOUSTIQUES (COMPOSANT A ONDES DE SURFACE)

(30) Priorität: 21.12.1995 DE 19548048
(43) Veröffentlichungstag der Anmeldung: 07.10.1998
(73) Patentinhaber: EPCOS AG, 81541 München (DE)
(72) Erfinder: PAHL, Wolfgang, D-80336 München (DE); STELZL, Alois, D-81549 München (DE); KRÜGER, Hans, D-81737 München (DE)
(74) Vertreter: Epping, Wilhelm, Dipl.-Ing.
(86) Internationale Anmeldenummer: DE9602411
(87) Internationale Veröffentlichungsnummer: WO9723952

(56) Entgegenhaltungen:
- DE-A- 3 138 743
- US-A- 4 293 986
- US-A- 4 639 631

## Beschreibung

Die vorliegende Erfindung betrifft ein elektronisches Bauelement, insbesondere mit akustischen Oberflächenwellen arbeitendes OFW-Bauelement, nach dem Oberbegriff des Patentanspruchs 1 sowie ein Verfahren zu dessen Herstellung.

In der älteren internationalen Patentanmeldung WO 95/30276 ist eine Verkapselung für elektronische Bauelemente mit einer Bauelemente-Strukturen auf einem Substrat verschließenden Kappe beschrieben, bei dem die Kappe durch eine auf einem Substrat vorgesehene Abdeckung gebildet ist, welche in Bereichen der Bauelemente-Strukturen diese aufnehmende Ausnehmungen besitzt. Eine derartige Verkapselung schützt die Bauelemente-Strukturen gegen Umwelteinflüsse, so daß derartig verkapselte elektronische Bauelemente ohne weiteres Gehäuse unmittelbar weiter verwendbar sind.

Die US-A-4,639,631 beschreibt ein OFW-Bauelement in SMD-Bauweise, bei dem das piezoelektrische Substrat mittels elektrisch leitendem Epoxydharz über einer Trägerplatte angeordnet und über das Substrat eine Kappe gestülpt ist, die auf der Trägerplatte dicht aufsitzt. Die elektrische Kontaktierung der elektrisch aktiven Strukturen auf dem piezoelektrischen Substrat erfolgt dabei über das elektrisch leitende Epoxydharz, eine Durchkontaktierung im Kappen- und Träger-plattenteil und Metallisierungen auf der Außenseite von Kappe und Trägerplatte.

Die dreiteilige Beschaffenheit dieses Bauelements - Trägerplatte, piezoelektrisches Substrat, Kappe - ist sehr aufwendig. Im übrigen ist dieses Bauelement nicht mit vernünftigem Aufwand in Massenfertigung herstellbar.

Mit zunehmender Miniaturisierung werden Bauelemente angestrebt, die ein minimales Gehäusevolumen beanspruchen und eine niedrige Bauhöhe besitzen. Derartige Anforderungen stellen sich beispielsweise bei der Anwendung von elektronischen Bauelementen in Chipkarten, wie etwa Telefonkarten oder Kreditkarten. Bauelemente mit einer Verkapselung nach der oben genannten PCT-Anmeldung erfüllen diese Anforderungen optimal.

Der vorliegenden Erfindung liegt die Aufgabe zugrunde, ein Bauelement der in Rede stehenden Art anzugeben, das für eine SMD-Montage und Massenfertigung geeignet ist.

Diese Aufgabe wird bei einem Bauelement der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

Die Erfindung wird nachstehend anhand eines Ausführungseispieles gemäß Zeichnung näher erläutert. Es zeigt:
- Figur 1: in schematischer Darstellung ein für eine SMD-Montage geeignetes erfindungsgemäßes OFW-Bauelement; und
- Figur 2: in schematischer Teildarstellung das Bauelement nach Figur 1 in Aufsicht.

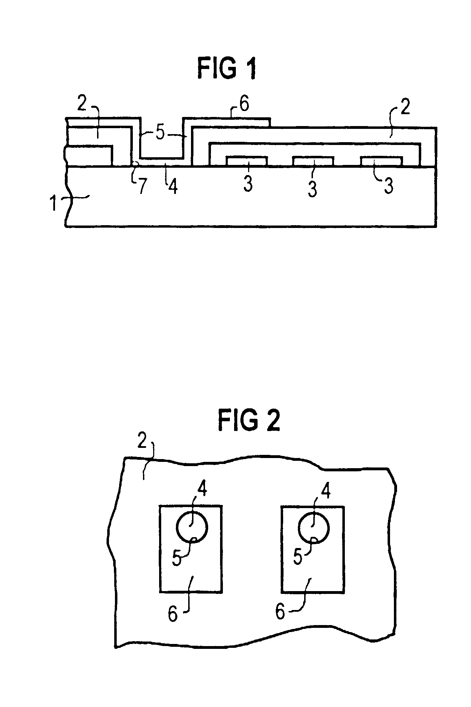

Gemäß Fig. 1 besteht ein OFW-Bauelement grundsätzlich aus einem piezoelektrischen Substrat 1 und darauf aufgebrachten leitenden Strukturen 3, bei denen es sich beispielsweise um Elektrodenfinger von Interdigitalwandlern, Resonatoren oder Reflektoren handeln kann. Wie in der eingangs genannten Patentanmeldung beschrieben ist, sind die elektrisch leitenden Strukturen 3 durch eine Kappe 2 gegen Umwelteinflüsse geschützt. Das Bauelement ist mit der Abdeckung 2 und dem Substrat 1 als "Gehäuse" direkt weiter verwendbar.

Erfindungsgemäß sind für eine SMD-Montage geeignete Kontakte für die elektrische Kontaktierung der leitenden Strukturen 3 vorgesehen. Gemäß Fig. 1 ist in der Abdeckung 2 eine sacklochförmige Durchführung 7 vorgesehen, in deren Bodenteil sich eine Pad-Metallisierung 4 befindet, die mit einer nicht dargestellten Anschlußfläche der elektrisch leitenden Strukturen 3 in Kontakt steht. Weiterhin ist auf der Abdeckung 2 eine für die SMD-Montage geeignete lötfähige Metallisierung 6 vorgesehen, welche über eine Durchkontaktierung 5 mit der Pad-Metallisierung 4 verbunden ist.

In Weiterbildung der Erfindung sind die Pad-Metallisierung 4, die Durchkontaktierung 5 und die lötfähige Metallisierung 6 auf der Abdeckung 2 aus dem gleichen Material hergestellt, wodurch sich eine günstige, wenig aufwendige Herstellung ergibt.

Mindestens die lötfähige Metallisierung 6 auf der Abdeckung 2 kann durch eine Materialschichtfolge Titan-Wolfram, Nickel, Gold gebildet sein, wobei Titan-Wolfram die Haftfähigkeit auf der Abdeckung 2, Nickel die Lötfähigkeit und Gold einen Oxidationsschutz gewährleisten. Die Schichtdicken von Titan-Wolfram sind vorzugsweise kleiner als 0,1µm, von Nickel etwa 1 µm und von Gold etwa 0,1 µm.

Eine besonders kostengünstige Variante besteht im Aufdampfen einer Schichtfolge aus TiW, Cu oder Ni und Au, deren Dicke insgesamt kleiner als 10 µm, vorzugsweise gleich 0,3 µm ist, der Strukturierung dieser Schicht durch gepulste Laserstrahlung und stromloser Verstärkung mit Cu. Dabei wird auch die Durchkontaktierung 5 erzeugt. Abschließend kann zur Passivierung Au in einer Dicke von 0,1 µm abgeschieden werden.

Da die Durchkontaktierungen 5 auf einer eine Vielzahl von Bauelementesystemen enthaltenden Substratscheibe erzeugt werden, können sie auch so positioniert sein, daß jeweils ein Teil der Durchkontaktierung jeweils einem Bauelementesystem zugeordnet ist, d.h. eine Durchkontaktierung für zwei Bauelementesysteme ausreicht.

Ebenso kann die Zuverlässigkeit dadurch erhöht werden, daß die Durchkontaktierungen redundant ausgeführt werden, d.h. einem Pad zwei Durchkontaktierungen zugeordnet werden.

## Patentansprüche

1. Elektronisches Bauelement, insbesondere mit akustischen Oberflächenwellen arbeitendes OFW-Bauelement mit für SMD-Montage geeigneten Kontakten, bei dem auf einem piezoelektrischen Substrat (1) vorgesehene elektrisch leitende Strukturen (3) durch eine kappenförmige Abdeckung (2) gegen Umwelteinflüsse dicht verkapselt sind, und in der Abdeckung (2) Durchkontaktierungen (5) vorgesehen sind, die elektrisch leitende Anschlußflächen - Pads - der elektrisch leitenden Strukturen mit lötfähigen Metallisierungen (6) auf der Abdekkung (2) verbinden,
**dadurch gekennzeichnet ,**
daß die Abdeckung (2) sacklochförmige Durchführungen (7) aufweist, daß die Abdeckung (2) und die Durchführungen (7) unmittelbar auf dem piezoelektrischen Substrat (1) aufsitzen und daß die Bodenteile der Durchführungen (7) die unmittelbar auf das Substrat (1) aufgebrachten Pad-Metallisierungen (4) sind, die mit den Strukturen (3) und über die Durchkontaktierungen (5) mit den lötfähigen Metallisierungen (6) elektrisch verbunden sind.

2. Elektronisches Bauelement nach Anspruch 1,
**dadurch gekennzeichnet ,**
daß die Pad-Metallisierungen (4), die Durchkontaktierungen (5) und die lötfähigen Metallisierungen (6) auf der Abdeckung (2) aus dem gleichen Material sind.

3. Elektronisches Bauelement nach Anspruch 1 und/oder 2,
**dadurch gekennzeichnet ,**
daß mindestens die lötfähigen Metallisierungen (6) auf der Abdeckung (2) aus einer Materialschichtfolge TiW, Ni, Au bestehen.

4. Elektronisches Bauelement nach Anspruch 3,
**dadurch gekennzeichnet ,**
daß TiW eine Schichtdicke von <0,1 µm, Nickel eine Schichtdicke von etwa 1 µm und Gold eine Schichtdicke von etwa 0,1 µm besitzen.

5. Verfahren zur Herstellung eines elektronischen Bauelements nach Anspruch 1,
bei dem auf einem piezoelektrischen Substrat (1) elektrisch leitende Strukturen (3) vorgesehen werden, durch eine kappenförmige Abdeckung (2) gegen Umwelteinflüsse verkapselt werden, bei dem in der Abdeckung sachlochförmige Durchführungen (7) vorgesehen werden, deren Bodenteile unmittelbar auf dem Substrat (1) aufgebrachte Pad-Metallisierungen sind, bei dem auf der Abdeckung (2) lötfähige Metallisierungen (6) vorgesehen werden und bei dem mittels Durchkontaktierungen (5) die Metallisierungen (6) mit den Pad-Metallisierungen (4) verbunden werden, wobei zumindest die lötfähigen Metallisierungen (6) durch Aufdampfen einer Schichtfolge TiW, Cu und Gold,

6. Verfahren nach Anspruch 5,
**dadurch gekennzeichnet**,
daß die Schichtfolge in einer Dicke von insgesamt 10 um erzeugt wird.

7. Verfahren nach Anspruch 6,
**dadurch gekennzeichnet**,
daß die Schichtfolge in einer Dicke von 0,1 um erzeugt wird.

8. Verfahren nach einem der Ansprüche 5 bis 7,
**dadurch gekennzeichnet**,
daß auf die Schichtfolge Gold in einer Dicke von 0,1 um abgeschieden wird.

9. Verfahren nach einem der Ansprüche 5 bis 8,
**dadurch gekennzeichnet**,
daß mit den Metallisierungen (6) die Durchkontaktierungen (5) erzeugt werden.

10. Verfahren nach einem der Ansprüche 5 bis 9,
**dadurch gekennzeichnet**,
daß jeweils einem Pad (3) mindestens zwei Durchkontaktierungen (5) zugeordnet werden oder einer Schichtfolge TiW, Ni und Gold, Strukturierung durch gepulste Laserstrahlung und stromloser Verstärkung mit Cu erzeugt werden.

11. Verfahren zur Massenfertigung eines elektronischen Bauelements nach Anspruch 1,
bei dem auf einem piezoelektrischen Substrat (1) elektrisch leitende Strukturen (3) vorgesehen werden, durch eine kappenförmige Abdeckung (2) gegen Umwelteinflüsse verkapselt werden, bei dem in der Abdeckung sachlochförmige Durchführungen (7) vorgesehen werden, deren Bodenteile unmittelbar auf dem Substrat (1) aufgebrachte Pad-Metallisierungen sind, bei dem auf der Abdeckung (2) lötfähige Metallisierungen (6) vorgesehen werden und bei dem mittels Durchkontaktierungen (5) die Metallisierungen (6) mit den Pad-Metallisierungen (4) verbunden werden, wobei die Durchführungen (7) und ihre Durchkontaktierungen (5) samt Metallisierungen (4, 6) auf einer eine Vielzahl von Bauelementesystemen enthaltenden Substratscheibe hergestellt und so positioniert werden, daß jeweils eine Durchkontaktierung (5) zwei Bauelementesystemen zugeordnet ist.

## Claims

1. Electronic component, in particular an SAW component operating with surface acoustic waves, having contacts which are suitable for SMD mounting and in the case of which electrically conductive structures (3) which are provided on a piezoelectric substrate (1) are encapsulated in a sealed manner against environmental influences by a cover (2) in the form of a cap, and through-plated holes (5) are provided in the cover (2), which through-plated holes (5) connect the electrically conductive connecting surfaces - pads - of the electrically conductive structures to metallized areas (6) which can be soldered on the cover (2), characterized in that the cover (2) has passages (7) in the form of blind holes, in that the cover (2) and the passages (7) are seated directly on the piezoelectric substrate (1) and in that the bottom parts of the passages (7) are pad metallized areas (4) which are applied directly to the substrate (1) and are electrically connected to the structures (3) and to the metallized areas (6), which can be soldered, via through-plated holes (5).

2. Electronic component according to Claim 1, characterized in that the pad metallized areas (4), the through-plated holes (5) and the metallized areas (6) which can be soldered on the cover (2) are made from the same material.

3. Electronic component according to Claim 1 and/or 2, characterized in that at least the metallized areas (6) which can be soldered on the cover (2) comprise a material layer sequence of TiW, Ni and Au.

4. Electronic component according to Claim 3, characterized in that the TiW has a layer thickness of < 0.1 µm, the nickel has a layer thickness of about 1 µm, and the gold has a layer thickness of about 0.1 µm.

5. Method for producing an electronic component according to Claim 1,
in which electrically conductive structures (3) are provided on a piezoelectric substrate (1), are encapsulated against environmental influences by means of a cover (2) in the form of a cap, in which method the cover has passages (7) in the form of blind holes, whose bottom parts are pad metallized areas applied directly on the substrate (1), in which method metallized areas (6) which can be soldered are provided on the cover (2), and in which method the metallized areas (6) are connected to the pad metallized areas (4) by means of through-plated holes (5), in which case at least the metallized areas (6) which can be soldered are produced by vapour deposition of a layer sequence of TiW, Cu and gold, or a layer sequence of TiW, Ni and gold, structuring by means of pulsed laser radiation, and non-electrical reinforcement with Cu.

6. Method according to Claim 5, characterized in that the layer sequence is produced with an overall layer thickness of 10 µm.

7. Method according to Claim 6, characterized in that the layer sequence is produced with a thickness of 0.1 µm.

8. Method according to one of Claims 5 to 7, characterized in that gold with a thickness of 0.1 µm is deposited onto the layer sequence.

9. Method according to one of Claims 5 to 8, characterized in that the through-plated holes (5) are produced with the metallized areas (6).

10. Method according to one of claims 5 to 9, characterized in that each pad (3) is allocated at least two through-plated holes (5).

11. Method for mass production of an electronic component according to Claim 1 in which electrically conductive structures (3) are provided on a piezoelectric substrate (1), are encapsulated against environmental influences by means of a cover (2) in the form of a cap, in which method the cover has passages (7) in the form of blind holes, whose bottom parts are pad metallized areas applied directly on the substrate (1), in which method metallized areas (6) which can be soldered are provided on the cover (2), and in which method the metallized areas (6) are connected to the pad metallized areas (4) by means of through-plated holes (5), the passages (7) and their through-plated holes (5) together with metallized areas (4, 6) being produced on a substrate wafer which contains a multiplicity of component systems and being positioned such that each through-plated hole (5) is allocated to two component systems.

## Revendications

1. Composant électronique, notamment composant à ondes de surface travaillant par des ondes acoustiques de surface, qui comporte des contacts convenant au montage SMD et dans lequel des structures (3) conductrices de l'électricité, prévues sur un substrat (1) piézo-électrique, sont blindées de manière étanche pour les protéger des influences extérieures par un revêtement (2) en forme de capot et dans lequel il est prévu dans le recouvrement (2) des trous (5) métallisés qui relient des surfaces de raccordement conductrices de l'électricité - pastilles - des structures conductrices de l'électricité à des métallisations (6) pouvant être brasées sur le recouvrement (2),
caractérisé en ce que le recouvrement (2) comporte des traversées (7) en forme de trous borgnes, en ce que le recouvrement (2) et les traversées (7) reposent directement sur le substrat (1) piézo-électrique et en ce que les parties de fond des traversées (7) sont les métallisations (4) en pastilles qui sont déposées directement sur le substrat (1) et qui sont reliées de manière conductrice de l'électricité aux structures (3) et, par l'intermédiaire des trous (5) métallisés, aux métallisations (6) pouvant être brasées.

2. Composant électronique suivant la revendication 1, caractérisé en ce que les métallisations (4) en pastilles, les trous (5) métallisés et les métallisations (6) pouvant être brasées sur le revêtement (2) sont en le même matériau.

3. Composant électronique suivant la revendication 1 et/ou 2, caractérisé en ce qu'au moins les métallisations (6) pouvant être brasées sur le recouvrement (2) sont en une succession de couches de matériau : TiW, Ni, Au.

4. Composant électronique suivant la revendication 3, caractérisé en ce que TiW a une épaisseur de couche de moins de 0,1 pm, le nickel une épaisseur de couche d'environ 1 µm et l'or une épaisseur de couche d'environ 0,1 µm.

5. Procédé de fabrication d'un composant électronique suivant la revendication 1, dans lequel on prévoit sur un substrat (1) piézo-électrique des structures conductrices de l'électricité qui sont blindées pour les protéger des influences extérieures par un recouvrement (2) en forme de capot, dans lequel on prévoit dans le recouvrement des traversées (7) en forme de trous borgnes dont les parties de fond sont des métallisations en pastilles déposées directement sur le substrat (1), dans lequel on prévoit sur le recouvrement (2) des métallisations (6) pouvant être brasées et dans lequel on relie au moyen de trous (5) métallisés les métallisations (6) aux métallisations (4) en pastilles, au moins les métallisations (6) pouvant être brasées étant produites par dépôt en phase vapeur d'une succession de couches : TiW, Cu ou or ou d'une succession de couches : TiW, Ni et or, structuration par faisceau laser pulsé et renforcement sans courant par du Cu.

6. Procédé suivant la revendication 5, caractérisé en ce que la succession de couches est produite en une épaisseur de 10 µm en tout.

7. Procédé suivant la revendication 6, caractérisé en ce que la succession de couches est produite en une épaisseur de 0,1 µm.

8. Procédé suivant l'une des revendications 5 à 6, caractérisé en ce que l'on dépose sur la succession de couches de l'or en une épaisseur de 0,1 µm.

9. Procédé suivant l'une des revendications 5 à 8, caractérisé en ce que l'on produit les trous (5) métallisés avec les métallisations (6).

10. Procédé suivant l'une des revendications 5 à 9, caractérisé en ce que l'on associe chaque fois au moins deux trous (5) métallisés à une pastille (3).

11. Procédé pour la fabrication de masse d'un composant électronique suivant la revendication 1, dans lequel on prévoit sur un substrat (1) piézo-électrique des structures (3) conductrices de l'électricité qui sont blindées pour les protéger des influences extérieures par un recouvrement (2) en forme de capot, dans lequel on prévoit dans le recouvrement des traversées (7) en forme de trous borgnes dont les parties de fond sont des métallisations en pastilles déposées directement sur le substrat (1), dans lequel on prévoit sur le recouvrement (2) des métallisations (6) pouvant être brasées et dans lequel les métallisations (6) sont reliées aux métallisations (4) en pastilles au moyen de trous (5) métallisés, les traversées (7) et leurs trous (5) métallisés, y compris les métallisations (4, 6), étant produites et positionnées sur une galette de substrat contenant une pluralité de systèmes de composants de manière que chaque fois un trou (5) métallisé soit associé à deux systèmes de composants.
